# EUROPEAN PATENT APPLICATION

(11) **EP 4 694 660 A1**
(43) Date of publication of application: **11.02.2026**
(21) Application number: 23930458.7
(22) Date of filing: 29.03.2023
(51) Int. Cl.: H10N 60/12, H10N 60/01

(54) **QUANTUM BIT DEVICE AND PRODUCTION METHOD FOR QUANTUM BIT DEVICE**

(71) Applicant: FUJITSU LIMITED, Kawasaki-shi, Kanagawa 211-8588 (JP)
(72) Inventor: HIROSE, Shinichi, Kawasaki-shi, Kanagawa 211-8588 (JP); KOUMA, Norinao, Kawasaki-shi, Kanagawa 211-8588 (JP); SAIDA, Daisuke, Kawasaki-shi, Kanagawa 211-8588 (JP)
(74) Representative: Haseltine Lake Kempner LLP
(86) International application number: PCT/JP2023/012915
(87) International publication number: WO 2024/201820

(57) **Abstract**

The qubit device includes a substrate that includes a groove, and a Josephson junction. The Josephson junction includes a first superconductor disposed within the groove, a barrier layer in contact with an upper surface of the first superconductor, and a second superconductor in contact with an upper surface of the barrier layer.

## Description

### TECHNICAL FIELD

This invention is concerning a quantum bit device and a method for manufacturing quantum bit device.

### BACKGROUND ART

Quantum computing utilizing the laws of quantum mechanics (for example, superposition and quantum entanglement) is realized by a quantum mechanical two-level system. A superconducting quantum bit (that is, a quantum bit that includes a superconductor) is one of potential candidates for such a two-level system.

A superconducting quantum bit is a quantum bit that includes a circuit element (for example, a capacitor) formed of a superconductor and a Josephson junction (for example, Patent Literatures 1 and 2 and Non-Patent Literatures 1 and 2). A Josephson junction of a superconducting quantum bit is manufactured by a manufacturing method in which oblique angle deposition and lift-off are combined (hereinafter, referred to as an oblique angle deposition method) (for example, Non-Patent Literatures 2 and 3).

As a method for manufacturing a Josephson junction, an oblique angle deposition method is widely used. However, a manufacturing method different from the oblique angle deposition method has also been proposed. For example, after an upper surface of a superconductor embedded in an insulator layer on a substrate is exposed, the upper surface is oxidized to form a barrier layer. In the proposed method, finally formed is a superconductor in contact with the barrier layer (Patent Literatures 2 and 3).

As an element that includes a superconductor, an element in which a superconductor is embedded in a trench formed in a semiconductor substrate has also been proposed (for example, Patent Literature 4). However, the element is a switching element.

### CITATION LIST

### PATENT LITERATURE

PATENT LITERATURE 1: Japanese Laid-open Publication No. 2020-61447
PATENT LITERATURE 2: US 2005/0197254 A1
PATENT LITERATURE 3: Japanese Laid-open Publication No. 61-174783
PATENT LITERATURE 4: Japanese Laid-open Publication No. 3-296284

### NON-PATENT LITERATURE

NON-PATENT LITERATURE 1: Eric Olson, "How quantum computers work", [online], 15 March 2019, Electronics 360, [Searched on December 8, 2022], Internet, <URL: https://electronics360.globalspec.com/article/13553/how-quantum-computers-work>
NON-PATENT LITERATURE 2: Tsuyoshi Yamamoto, "Basic knowledge for understanding research on quantum computers using superconducting circuits", Journal of the Physical Society of Japan, The Physical Society of Japan, 2020, Vol. 75, No. 10, p. 610-617
NON-PATENT LITERATURE 3: A. POTTS et. al., "Novel fabrication methods for submicrometer Josephson junction qubits", JOUNAL OF MATERIALS SCIENCE: MATERIALS IN ELECTRONICS, 2001, Vol.12, p.289-293
NON-PATENT LITERATURE 4: N A Court et. al., "Energy gap measurement of nanostructured thin aluminium films for use in single Cooper-pair devices", [online], 1 February 2008, Cornell University, [Searched on December 8, 2022], Internet, <URL: https://arxiv.org/abs/0706.4150v1>

### SUMMARY OF INVENTION

### PROBLEMS TO BE SOLVED BY THE INVENTION

In a quantum bit device that includes a fabricated Josephson junction, there is a problem that the film thickness of a barrier layer decreases at a specific location. Therefore, an object of the present invention is to solve such a problem.

### MEANS FOR SOLVING THE PROBLEMS

In one embodiment, a quantum bit device includes: substrate; and a Josephson junction, wherein the substrate includes a groove, and the Josephson junction includes: a first superconductor disposed inside the groove; a barrier layer in contact with an upper surface of the first superconductor; and a second superconductor in contact with an upper surface of the barrier layer.

### ADVANTAGEOUS EFFECTS OF THE INVENTION

In one aspect, according to the present invention, in a quantum bit device that includes a Josephson junction, it is possible to suppress a decrease in the film thickness of a barrier layer at a specific location.

### BRIEF DESCRIPTION OF DRAWINGS

FIG. 1 is a plan view of an example of a quantum bit device according to a first embodiment.
FIG. 2 is an enlarged view of an area 3 surrounded by a broken line in FIG. 1.
FIG. 3 is a cross-sectional view taken along line III-III of FIG. 2.
FIG. 4 is a circuit diagram of the quantum bit device 2 illustrated in FIG. 1.
FIG. 5 is a cross-sectional view taken along line V-V in FIG. 2.
FIG. 6 is a diagram that illustrates the energy level of the parallel resonance circuit.
FIG. 7 is a cross-sectional view of a superconductor 9 disposed on a substrate 7.
FIG. 8 is a process flowchart that illustrates an example of a method for manufacturing the quantum bit device 2.
FIGs. 9A and 9B are process cross-sectional views taken along line V-V illustrated in FIG. 2.
FIGs. 10A and 10B are process cross-sectional views taken along line V-V illustrated in FIG. 2.
FIGs. 11A and 11B are process cross-sectional views taken along line V-V illustrated in FIG. 2.
FIGs. 12A and 12B are process cross-sectional views taken along line III-III illustrated in FIG. 2.
FIGs. 13A and 13B are process cross-sectional views taken along line III-III illustrated in FIG. 2.
FIGs. 14A and 14B are process cross-sectional views taken along line III-III illustrated in FIG. 2.
FIG. 15 is process cross-sectional views taken along line III-III illustrated in FIG. 2.
FIG. 16 is a plan view of a quantum bit device 202 in which a Josephson junction is formed by an oblique angle deposition method.
FIG. 17 is an enlarged view of an area 203 surrounded by a broken line in FIG. 16.
FIG. 18 is a cross-sectional view taken along line XVIII-XVIII in FIG. 17.
FIG. 19 is a perspective view of a Josephson junction 206 that the oblique angle deposition element 202 includes and the vicinity thereof.
FIG. 20 is a cross-sectional view across the Josephson junction 206.
FIG. 21 is a diagram for explaining an oblique angle deposition method.
FIG. 22 is a process flowchart that illustrates a method for manufacturing the oblique angle deposition element 202.
FIG. 23 is a plan view of an example of a quantum bit device according to a second embodiment.

### DESCRIPTION OF EMBODIMENTS

Embodiments of the present invention will be described hereinafter according to drawings. However, it is noted that the technical scope is not limited to the embodiments described below, but covers the matters described in the claims and the equivalents thereof. Here, identical symbols are given to parts with identical structure and the like even in different drawings, and the description thereof will be omitted.

### (First Embodiment)

### (1) Structure

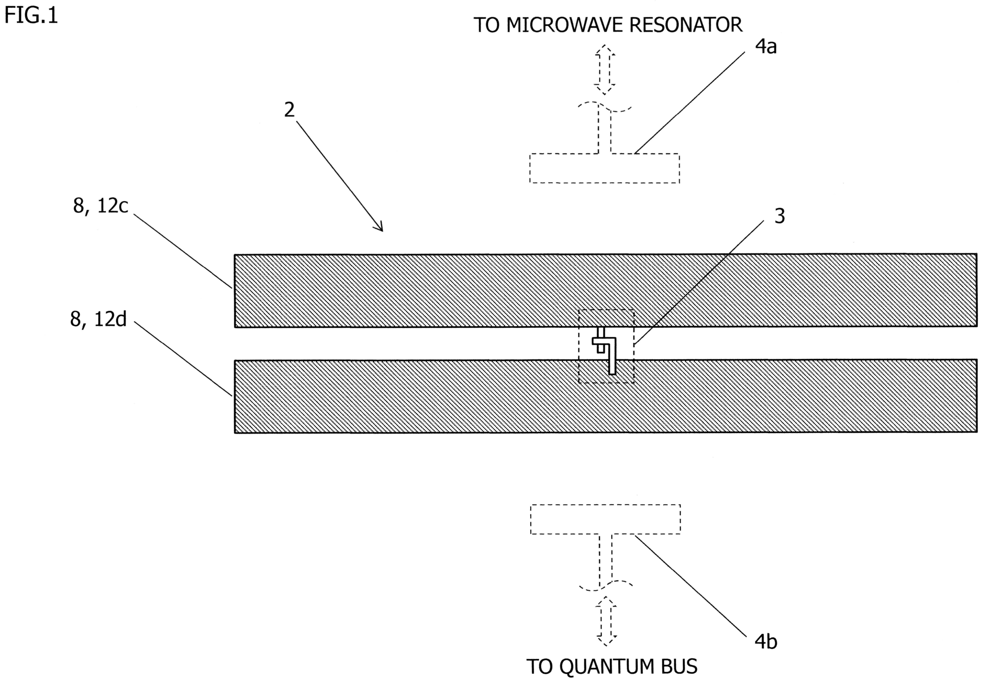

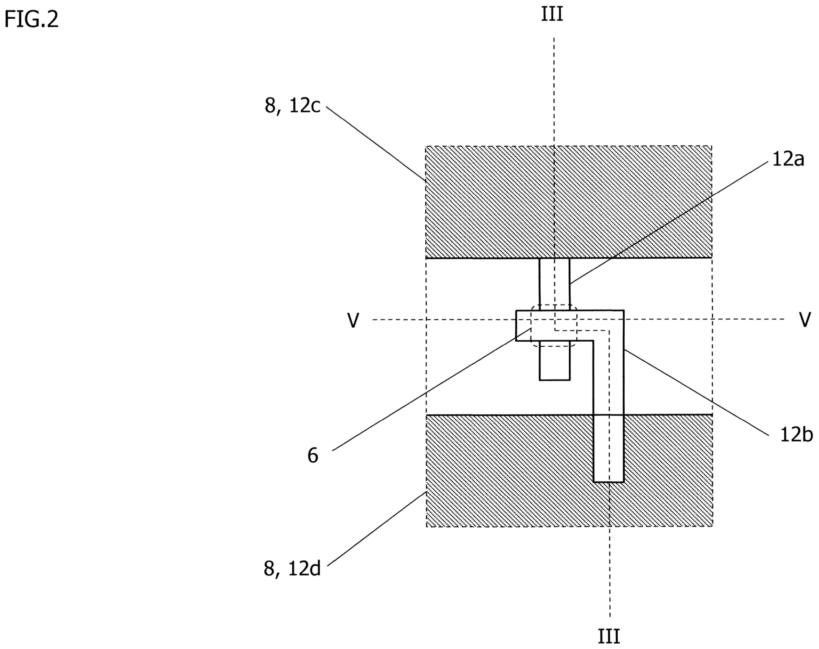

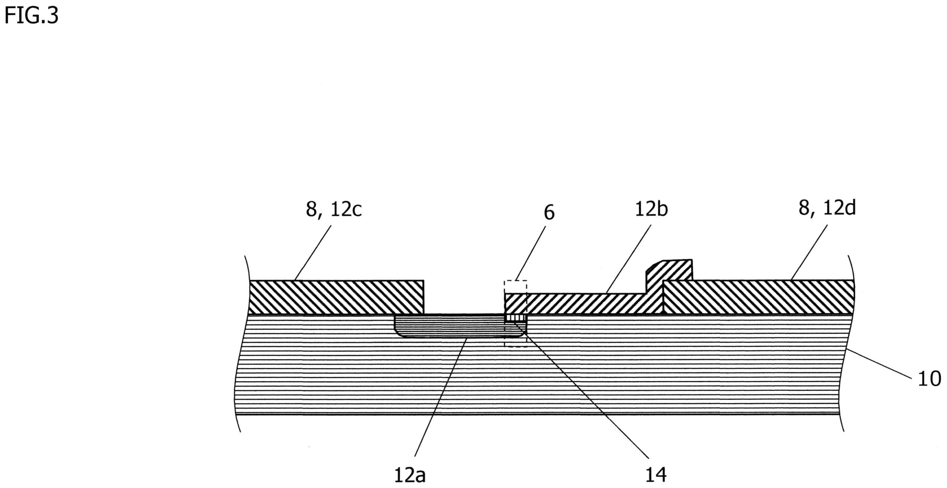

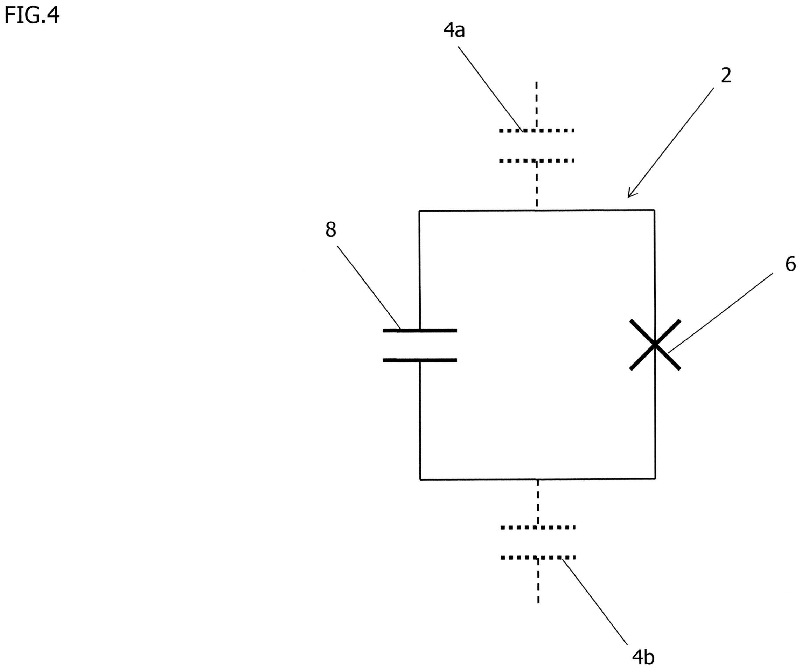

FIG. 1 is a plan view of an example of a quantum bit device according to a first embodiment (hereinafter, referred to as a quantum bit device 2). FIG. 2 is an enlarged view of an area 3 surrounded by a broken line in FIG. 1. FIG. 3 is a cross-sectional view taken along line III-III of FIG. 2. FIG. 4 is a circuit diagram of the quantum bit device 2 illustrated in FIG. 1.

In FIGS. 1 and 4, in addition to the quantum bit device 2, a first capacitor 4a that couples the quantum bit device 2 and a microwave resonator (see a second embodiment) is illustrated. FIGS. 1 and 4 further illustrate a second capacitor 4b that couples the quantum bit device 2 and a quantum bus (see the second embodiment). As illustrated in FIGS. 2 and 4, the quantum bit device 2 includes a capacitor 8 and a Josephson junction 6. In FIG. 2, a broken line frame at the tip of a lead line that extends from a reference sign "6" indicates an area slightly wider than the area in which the Josephson junction 6 exists (the same applies below).

The quantum bit device 2 includes a substrate 10 (see FIG. 3) that includes a groove, and a first superconductor 12a (see FIGS. 2 and 3) disposed inside the groove. The quantum bit device 2 further includes a barrier layer 14 (see FIG. 3) in contact with the first superconductor 12a, and a second superconductor 12b (see FIGS. 2 and 3) in contact with the barrier layer 14. The barrier layer 14 is a substance (for example, an insulator) different from superconductor. The barrier layer is a layer through which a Cooper pair passes by a tunneling effect.

The quantum bit device 2 further includes a third superconductor 12c in contact with the first superconductor 12a, and a fourth superconductor 12d in contact with the second superconductor 12b (see FIGS. 2 and 3).

The capacitor 8 is a circuit element that includes the third superconductor 12c and the fourth superconductor 12d. The Josephson junction 6 (see FIG. 3) is a junction that includes a portion of the first superconductor 12a, at least a portion of the barrier layer 14, and a portion of the second superconductor 12b, in this order. In other words, the Josephson junction 6 includes the first superconductor 12a disposed inside the groove of the substrate 10, the barrier layer 14 in contact with the upper surface of the first superconductor 12a, and the second superconductor 12b in contact with the upper surface of the barrier layer 14.

In FIGS. 2 and 3, the barrier layer 14 is drawn to be localized between the first superconductor 12a and the second superconductor 12b. However, the barrier layer 14 may be a layer spreading from between the first superconductor 12a and the second superconductor 12b to the outside (see "(4-6) Step S12 (fifth step)" in "(4) Manufacturing method").

The first superconductor 12a is metal (for example, aluminum). The barrier layer 14 is preferably a substance (for example, aluminum oxide) obtained by oxidizing the metal (for example, aluminum).

The second superconductor 12b is also the above metal (for example, aluminum), preferably. The third superconductor 12c and the fourth superconductor 12d are, for example, any of Nb, TiN, and Ta. The substrate 10 is, for example, silicon or sapphire.

### -Outer shape of the first superconductor 12a-

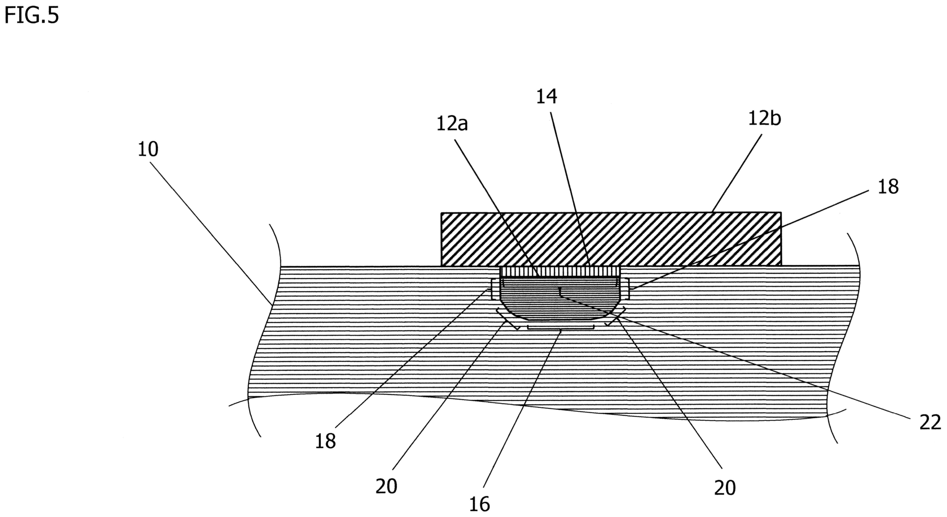

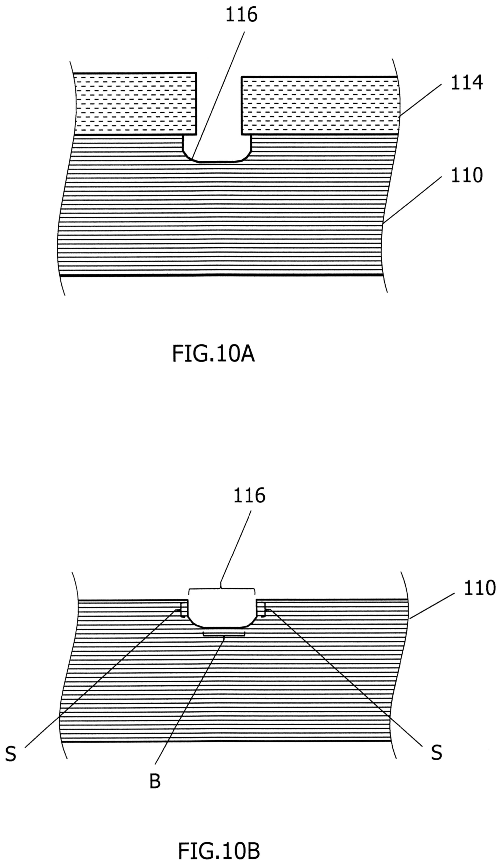

FIG. 5 is a cross-sectional view taken along line V-V in FIG. 2. As illustrated in FIG. 5, the first superconductor 12a includes a lower surface 16 in contact with the bottom of a groove (see a groove 116 in FIG. 10(b)) of the substrate 10, a side surface 18 extending along the lower surface 16 (that is, along the longitudinal direction of the groove), and a curved surface 20 located between the lower surface 16 and the side surface 18. That is, the first superconductor 12a includes the lower surface 16 in contact with the bottom of the groove that substrate 10 has, the side surface 18 in contact with the side wall of the groove that substrate 10 has, and the curved surface 20 located between the lower surface 16 and the side surface 18.

The first superconductor 12a further includes a plane 22 that is separated from the bottom of the groove of the substrate 10 and is in contact with the sidewall of the groove of the substrate 10 and the barrier layer 14.

When the first superconductor 12a includes a sharp corner (for example, a corner of a rectangular parallelepiped), an electric field concentrates on the corner. Then, the coherence time (that is, the time during which the superposition state of the quantum bits is maintained) of the quantum bit device 2 is shortened. However, as illustrated in FIG. 5, since the first superconductor 12a includes the curved surface 20 instead of the sharp corner, shortening of the coherence time (that is, the decoherence) due to electric field concentration hardly occurs.

### (2) Operation

The Josephson junction is a non-linear inductor in which the inductance depends on the current. The quantum bit device 2 (see FIG. 4) is a parallel resonance circuit (so-called transmon) of the Josephson junction 6 that is a nonlinear inductor, and the capacitor 8.

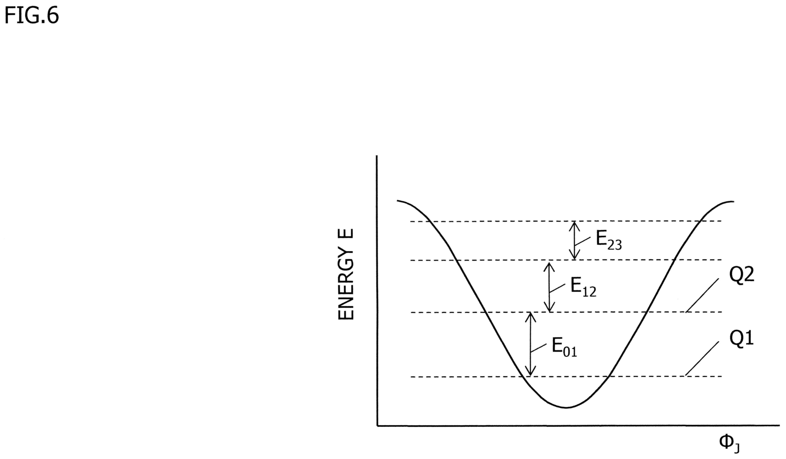

FIG. 6 is a diagram that illustrates the energy level of the parallel resonance circuit (see, for example, Non-Patent Literature 2). The vertical axis represents the energy E of the electric oscillation generated in the quantum bit device 2.

The horizontal axis represents a generalized magnetic flux Φ_{J}. The generalized magnetic flux Φ_{J} is a physical quantity proportional to the gauge phase difference between two superconductors (for example, the first and second superconductors 12a and 12b) that the Josephson junction includes.

The energy E of a parallel resonator that includes a non-linear inductor is discrete and the interval thereof (for example, E₀₁, E₁₂, and E₂₃ in FIG. 6) gradually narrows. Therefore, the quantum bit device 2 is a system that can be handled as a two-level system in which only two quantum states (specifically, the lowest energy excited state and the ground state) exist.

When the quantum bit device 2 is cooled to near absolute zero, the thermal energy kT (k represents a Boltzmann constant, and T represents an absolute temperature) becomes sufficiently smaller than the energy difference E₀₁ of the two lowest levels. Then, the quantum bit device 2 is thermally hardly excited from the ground state to the excited state. As a result, the quantum bit device 2 becomes operable as a quantum bit. Therefore, the quantum bit device 2 is used in a state of being cooled to near absolute zero by, for example, a dilution refrigerator.

As described above, the quantum bit device 2 is a quantum bit, in which a first quantum state (specifically, a ground state Q1) and a second quantum state (specifically, a lowest energy excited state Q2) that has higher energy than that of the first quantum state, exist.

### (3) Characteristics

The characteristics (for example, the resonance frequency) of the quantum bit device 2 depend on an inductance L_{J} of the Josephson junction 6 and the capacitance of the capacitor 8. The inductance L_{J} is a nonlinear inductance that depends on the ratio (= I/I_{C}) of the current I that flows through the Josephson junction 6 to the critical current I_{C} (see, for example, Non-Patent Literature 2).

As is well known, the critical current I_{C} of the Josephson junction depends on a superconducting gap Δ and a tunnel resistance R. Therefore, the characteristics of the quantum bit device 2 (that is, transmon) that includes the Josephson junction 6 depend on the superconducting gap Δ and the tunnel resistance R. The same applies to other quantum bit devices that include a Josephson junction (for example, a magnetic flux quantum bit).

Here, the superconducting gap Δ is an energy gap of superconductors (for example, the first and second superconductors 12a and 12b) included in the Josephson junction. The tunnel resistance R is an electrical resistance observed when quasi-particles (that is, holes and electrons) generated by the destruction of the Cooper pair pass through the barrier layer of the Josephson junction by the tunnel effect.

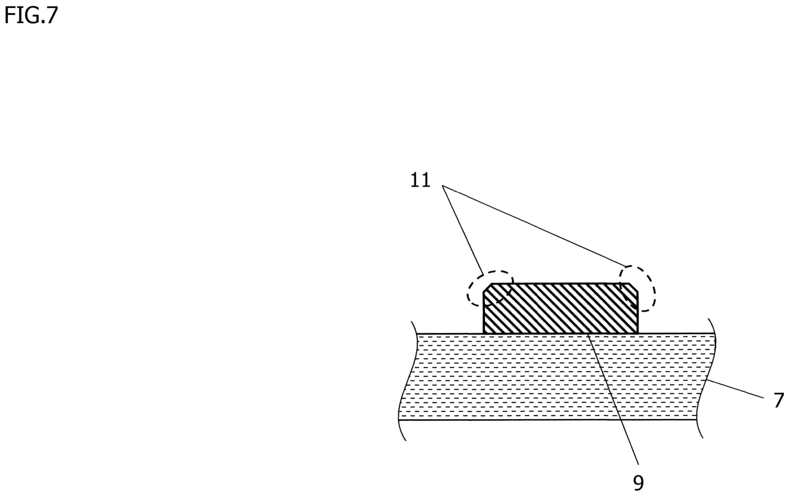

FIG. 7 is a cross-sectional view of a superconductor 9 disposed on a substrate 7. When a barrier layer (for example, an oxide film) that covers the superconductor 9 is formed, the barrier layer may become thin at a corner 11 of the superconductor 9 (see "(5) Comparison with quantum bit device formed by oblique angle deposition").

As is also well known, as the barrier layer becomes thinner, the tunnel resistance R decreases. Therefore, when the barrier layer becomes thin at the corner 11 of the superconductor 9, the tunnel resistance R deviates from a predetermined value (hereinafter referred to as a planned value) (hereinafter, referred to as a fact 1).

For example, in a case where the barrier layer is formed by exposing the superconductor 9 to oxygen, the time for exposing the superconductor 9 to oxygen (hereinafter referred to as an exposure time) is adjusted in advance so that the actual tunnel resistance R matches the planned value thereof. However, even if the superconductor 9 is exposed to oxygen for the exposure time adjusted in advance, when the barrier layer becomes thin at the corner 11 of the superconductor 9, the actual tunnel resistance R deviates from the planned value.

As described above, the characteristics of the quantum bit device that includes the Josephson junction depend on the tunnel resistance R and the energy gap Δ. Therefore, when the tunnel resistance R deviates from the planned value, the characteristics of the quantum bit device that includes the Josephson junction deviate from the target value (that is, the design value) (hereinafter, referred to as a fact 2).

As is clear from the facts 1 and 2, when the barrier layer becomes thinner at the corner 11 of the superconductor 9, the characteristics of the quantum bit device that includes the Josephson junction deviate from the target value (hereinafter referred to as a conclusion 1).

As described above, the barrier layer (hereinafter, referred to as an enveloping barrier layer) that covers the superconductor 9 on the substrate may be thin at the corner 11 of the superconductor. Therefore, as is clear from the conclusion 1, the characteristics of the quantum bit device with the enveloping barrier layer, which may be thinned at the corner 11 of the superconductor 9, may deviate from the target value. For this reason, the yield of the quantum bit device with the enveloping barrier layer (that is, the barrier layer that covers the superconductor on the substrate) may be lowered.

As illustrated in FIG. 5, the barrier layer 14 according to the first embodiment covers the upper surface of first superconductor 12a, but does not cover the corners of first superconductor 12a (in the example illustrated in FIG. 5, the boundary between the side surface 18 and the upper surface (that is, the plane 22) and the vicinity thereof). Therefore, due to the thinning of the barrier layer at the corner of the superconductor, it is possible to suppress a decrease in the yield of the quantum bit device 2.

The superconducting gap Δ depends on the film thickness of the superconductor (see, for example, Non-Patent Literature 4). Therefore, when the superconductor is formed by a method in which the variation in the film thickness is large (for example, "oblique angle deposition method" to be described later), the variation in the superconducting gap Δ is also large (hereinafter, referred to as a fact 3.).

As described above, the characteristics of the quantum bit device that includes the Josephson junction depend on the superconducting gap Δ and the tunnel resistance R. Therefore, when the variation in the superconducting gap Δ is large, the variation in the characteristics of the quantum bit device that includes the Josephson junction is also large (hereinafter, referred to as a fact 4).

As is clear from the facts 3 and 4, when the superconductor is formed by a method in which the variation in film thickness is large, the variation in the characteristics of the quantum bit device that includes the Josephson junction becomes large. As a result, a large number of devices whose characteristics deviate from the target values (that is, the design values) are formed. That is, when the superconductor is formed by a method in which the variation in film thickness is large, the yield of the quantum bit device that includes the Josephson junction decreases.

On the other hand, the superconductors (that is, the first and second superconductors 12a and 12b) according to the first embodiment are formed by a method in which the film thickness is less likely to vary (see "(5) Comparison with quantum bit device formed by oblique angle deposition"). Therefore, it is possible to suppress a decrease in the yield of the quantum bit device 2, the decrease being due to the variation in the film thickness of the superconductor.

### (4) Manufacturing method

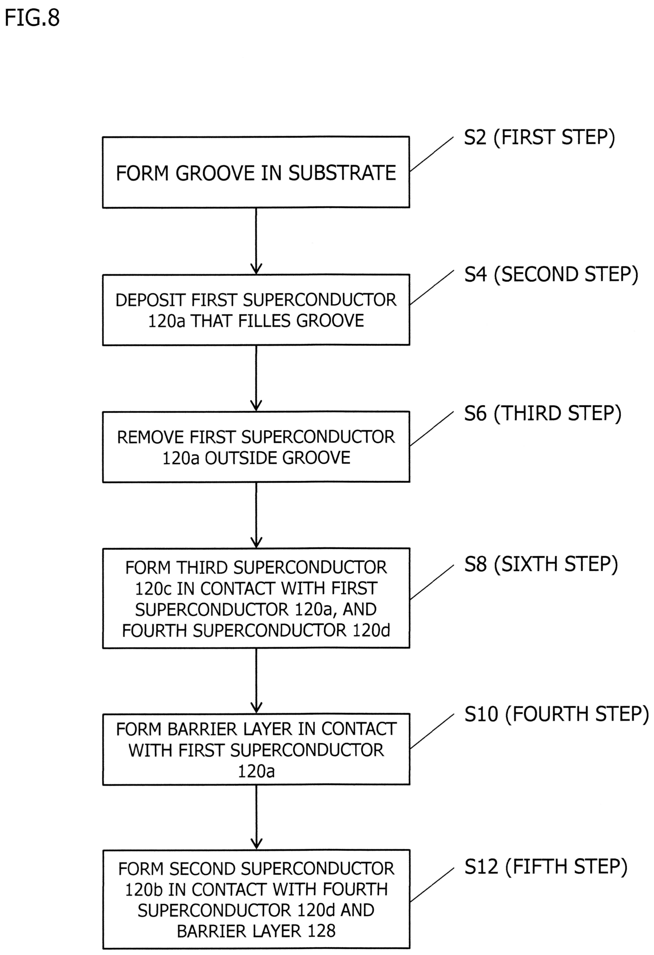

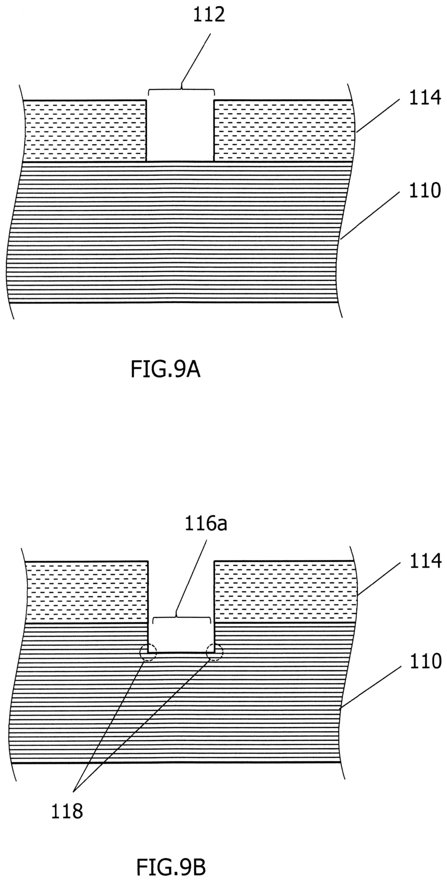

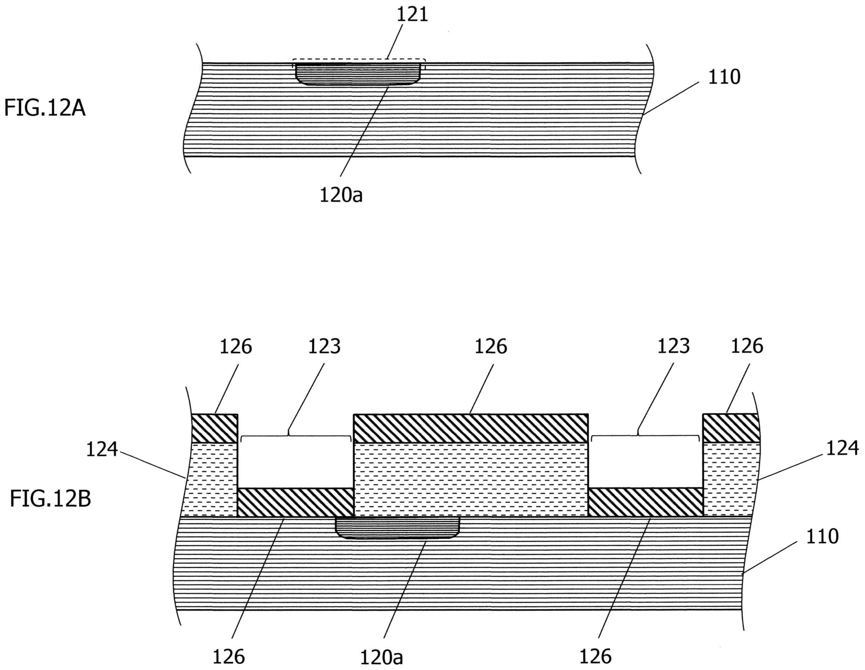

FIG. 8 is a process flowchart that illustrates an example of a method for manufacturing the quantum bit device 2. FIGS. 9 to 11 are process cross-sectional views taken along line V-V illustrated in FIG. 2. FIGS. 12 to 15 are process cross-sectional views taken along line III-III illustrated in FIG. 2.

### (4-1) Step S2 (first step)

First, a groove is formed in a substrate.

Specifically, for example, a photoresist film 114 that includes an elongated opening 112 is formed on a silicon substrate 110 (see FIG. 9 (a)). Thereafter, a groove 116a (hereinafter, referred to as a first groove) is formed in the silicon substrate 110 by dry etching through the opening 112 of the photoresist film 114 (see FIG. 9 (b)).

The opening 112 is formed using, for example, an electron lithography apparatus (the same applies below). The dry etching used for forming the groove 116a is, for example, inductively coupled plasma etching (IPC) using a mixed gas of CF₄ and O₂ as a reaction gas. The depth of the groove 116a is, for example, 10 nm to 40 nm (preferably 20 nm).

Next, a portion of the silicon substrate 110 that is in contact with the first groove 116a is removed by wet etching (see FIG. 10(a)). The etching solution is, for example, a mixed solution obtained by diluting nitrohydrofluoric acid with acetic acid.

Finally, the photoresist film 114 is removed (see FIG. 10(b)). As a result, the silicon substrate 110 that includes the groove 116 is formed. The silicon substrate 110 is an example of the substrate 10 illustrated in FIGS. 3 and 5.

A damage layer (that is, a layer damaged by dry etching) extends from the surface of the first groove 116a (see FIG. 9(b)) to a certain depth. The damage layer is removed by wet etching of the silicon substrate 110. The thickness of the damage layer to be removed is 2 nm to 10 nm (preferably, 5 nm).

The first groove 116a obtained by dry etching includes a corner 118 (see FIG. 9(b)). The corner disappears by the wet etching of the silicon substrate 110, and the groove 116 that includes no corner (that is, an edgeless groove) is formed (see FIGS. 10(a) and 10(b)).

### (4-2) Step S4 (second step)

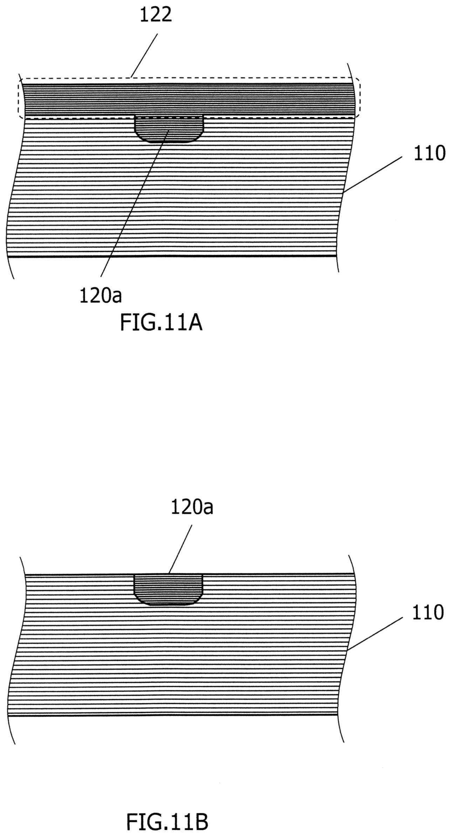

After step S2, a superconductor 120a (hereinafter, referred to as a first superconductor 120a) that fills the groove 116 is deposited on the silicon substrate in which the groove 116 is formed, by vacuum deposition, for example (see FIG. 11(a)). In other words, the first superconductor 120a is deposited on the upper surface of the substrate 110 and inside the groove 116. The first superconductor 120a is, for example, aluminum.

### (4-3) Step S6 (third step)

After step S4, a portion 122 (appropriately referred to as a first portion) of the first superconductor 120a that is located outside the groove 116 is removed by, for example, chemical mechanical polishing (see FIGS. 11(b) and 12(a)). In other words, the first portion 122 of the first superconductor 120a that is formed on the upper surface of the substrate 110 is removed by, for example, chemical mechanical polishing. As a result, the first superconductor 120a is localized in the groove 116.

By using chemical mechanical polishing, the first superconductor 120a that includes an upper surface with high flatness is obtained. The first portion 122 (see FIG. 11(a)) may be removed by a method different from chemical mechanical polishing (for example, wet etching).

### (4-4) Step S8 (sixth step)

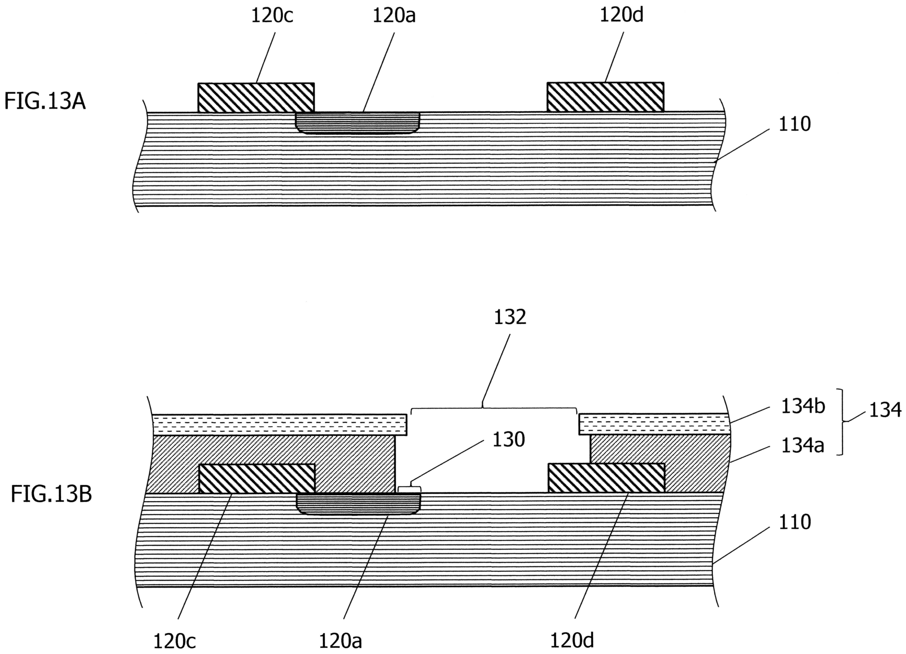

After step S6, a third superconductor 120c in contact with a portion of the first superconductor 120a, and a fourth superconductor 120d are formed by, for example, lift-off (see FIG. 13(a)). The third superconductor 120c is an example of the third superconductor 12c illustrated in FIG. 3. The fourth superconductor 120d is an example of the fourth superconductor 12d illustrated in FIG. 3.

The third superconductor 120c and the fourth superconductor 120d are preferably formed after an oxide film (not illustrated) that covers the upper surface 121 (see FIG. 12(a)) of the first superconductor 120a is removed or reduced. Here, the "upper surface 121 of the first superconductor 120a" is a surface of the first superconductor 120a, and is a surface separated from the bottom B of the groove 116. Its outer periphery is in contact with each side surface S of the groove 116 (see FIG. 10(b)).

Specifically, first, the first superconductor 120a and the silicon substrate 110 are exposed to vapor hydrofluoric acid (Vapor HF) to remove an oxide film that covers the upper surfaces of the first superconductor 120a and the silicon substrate 110. The oxide film may be reduced by, for example, plasma reduction treatment.

The plasma reduction treatment is a treatment for reducing the oxide on the surface by exposing the oxidized material surface to hydrogen plasma. According to the plasma reduction treatment or the vapor hydrofluoric acid, it is possible to realize a surface without an oxide film while maintaining high flatness of the upper surface of the first superconductor 120a.

Next, formed is a photoresist film 124 (see FIG. 12(b)) that includes an opening 123 that partially exposes each of the first superconductor 120a and the silicon substrate 110. When the quantum bit device 2 (see FIGS. 1 to 3) is manufactured, the actual width (the length in the horizontal direction, in the case of FIG. 12(b)) of the opening 123 is longer than that of the first superconductor 120a. However, in FIG. 12(b), the width of the opening 123 is described to be substantially the same as the length of the first superconductor 120a. The same applies to the widths of the third superconductor 120c and the fourth superconductor 120d illustrated in FIGS. 13(a) to 15.

Thereafter, the superconductor 126 (for example, Nb, TiN, or Ta) is deposited on the silicon substrate 110 on which the photoresist film 124 is formed, by sputtering, for example. Finally, the superconductor 126 deposited on the photoresist film 124 is removed together with the photoresist film 124. As a result, the third superconductor 120c in contact with the first superconductor 120a and the fourth superconductor 120d are formed (see FIG. 13(a)).

### (4-5) Step S10 (fourth step)

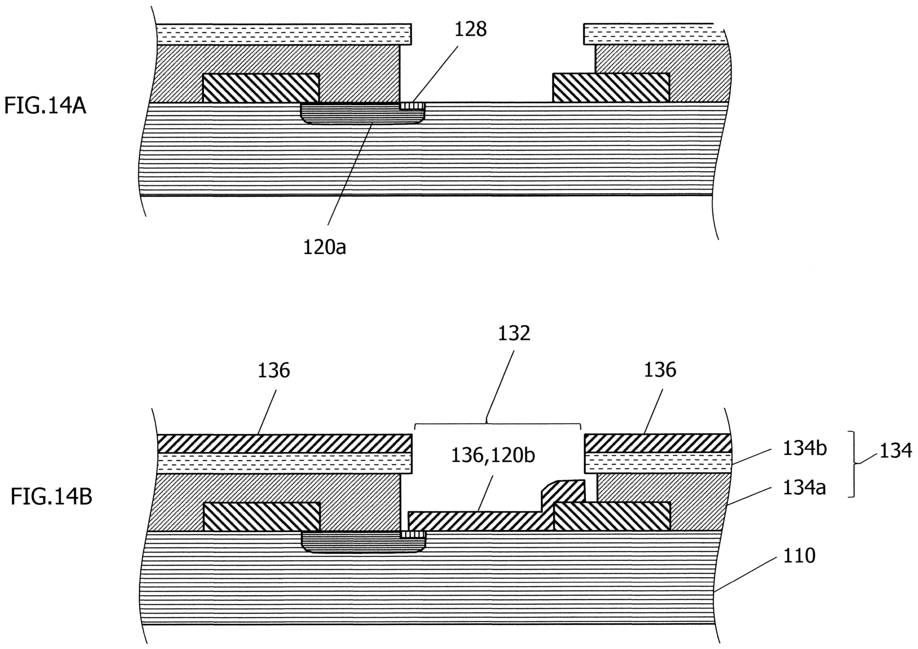

After step S8, a barrier layer 128 (see FIG. 14(a)) in contact with the upper surface (appropriately referred to as a first upper surface) of the first superconductor 120a is formed. In other words, the barrier layer 128 is formed on the first upper surface of the first superconductor 120a. The barrier layer 128 is an example of the barrier layer 14 illustrated in FIG. 3. The barrier layer 128 is a substance different from superconductor.

The barrier layer 128 is preferably formed by removing or reducing an oxide film (not illustrated) that covers a portion 130 (hereinafter, referred to as a second portion) of the upper surface of the first superconductor 120a (see FIG. 13(b)), and then exposing the portion (that is, the second portion 130) to oxygen.

Specifically, first, a two-layer resist film 134 (see FIG. 13(b)) that includes an opening 132 is formed on the silicon substrate 110 in which the first superconductor 120a is embedded. The opening 132 partially exposes each of the upper surface of the first superconductor 120a, the upper surface of the silicon substrate 110, and the fourth superconductor 120d.

The two-layer resist film 134 includes a copolymer layer 134a in contact with the silicon substrate 110, and a photoresist film 134b that is in contact with the copolymer layer 134a and includes eaves (that is, a portion that protrudes from the copolymer layer 134a).

The oxide film that covers the portion (that is, the second portion 130) of the upper surface of the first superconductor 120a is removed by exposing the portion (that is, the second portion 130) of the upper surface of the first superconductor 120a and the like to vapor hydrofluoric acid (Vapor HF) through the opening 132 of the two-layer resist film 134. The oxide film may be reduced by plasma reduction treatment.

Thereafter, the silicon substrate 110 from which the oxide film that covers the second portion 130 has been removed is attached to an evaporative apparatus. The evaporative apparatus to which the silicon substrate 110 is attached is exhausted, and then oxygen is introduced into the evaporative apparatus. Then, the second portion 130 from which the oxide film has been removed is exposed to oxygen, and an oxide film that has a film thickness corresponding to the oxygen introduction time is formed. The "oxygen introduction time" is a time during which oxygen is introduced into the evaporative apparatus.

The oxide film is the barrier layer 128 (see FIG. 14(a)). Instead of oxygen, a mixed gas of oxygen and argon may be introduced. The thickness of the barrier layer 128 is, for example, 1 nm to 5 nm. The pressure of oxygen introduced into the evaporative apparatus is, for example, 1 Torr to 10 Torr.

The barrier layer 128 is an example of the barrier layer 14 illustrated in FIG. 3. The first superconductor 120a is slightly deformed in cross section due to the formation of the barrier layer 128. The first superconductor 120a (see FIG. 14(a)) whose cross section is deformed is an example of the first superconductor 12a illustrated in FIG. 3.

### (4-6) Step S12 (fifth step)

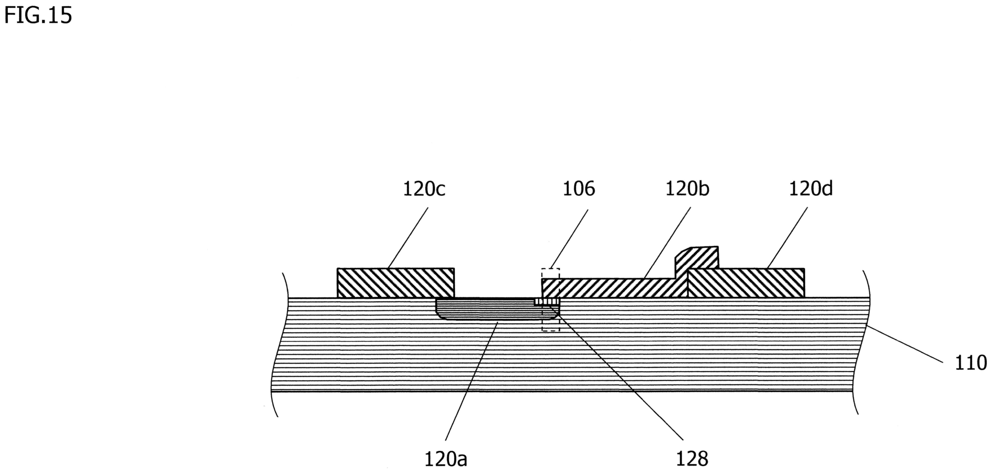

After step S10, a Josephson junction 106 (see FIG. 15) is formed by forming a second superconductor 120b on the upper surface of the barrier layer 128. Specifically, the Josephson junction 106 (see FIG. 15) is formed by forming the second superconductor 120b in contact with the fourth superconductor 120d and the upper surface of the barrier layer 128.

In other words, formed is the Josephson junction 106 that includes a portion of the first superconductor 120a, at least a portion of the barrier layer 128, and a portion of the second superconductor 120b. The Josephson junction 106 is an example of the Josephson junction 6 illustrated in FIG. 3.

Specifically, first, oxygen is exhausted from the evaporative apparatus in which the barrier layer 128 is formed. Thereafter, a superconductor 136 (for example, aluminum) is deposited on the silicon substrate 110 via the opening 132 of the two-layer resist film 134 by the evaporative apparatus (see FIG. 14(b)). Finally, the superconductor 136 deposited on the two-layer resist film 134 is removed together with the two-layer resist film 134. As a result, the second superconductor 120b in contact with the fourth superconductor 120d and the barrier layer 128 is obtained (see FIG. 15). The second superconductor 120b is an example of the second superconductor 12b illustrated in FIG. 3.

There is a case where the second superconductor 120b is not deposited immediately below the eaves that the two-layer resist film 134 includes. As a result, a portion of the barrier layer 128 exists outside between the first superconductor 120a and the second superconductor 120b (see FIG. 15). That is, the Josephson junction 106 is a junction that includes a portion of the barrier layer 128.

If a single-layer resist is used instead of the two-layer resist film 134, the barrier layer 128 localized between the first superconductor 120a and the second superconductor 120b is formed. In this case, the entire barrier layer 128 exists between the first superconductor 120a and the second superconductor 120b.

In the example illustrated in FIG. 8, the third and fourth superconductors 120c and 120d are formed before the Josephson junction 106 is formed. However, the third and fourth superconductors 120c and 120d may be formed after the Josephson junction 106 is formed. That is, step S8 (that is, the sixth step) may be performed after step S12 (that is, the fifth step).

However, in step S12, instead of the "second superconductor 120b in contact with the fourth superconductor 120d and the barrier layer 128", the "second superconductor 120b in contact with the barrier layer 128" is formed. In step S8 (that is, the sixth step), instead of the "fourth superconductor 120d", "fourth superconductor 120d in contact with the second superconductor 120b" is formed.

### (5) Comparison with quantum bit device formed by oblique angle deposition

### (5-1) Structure

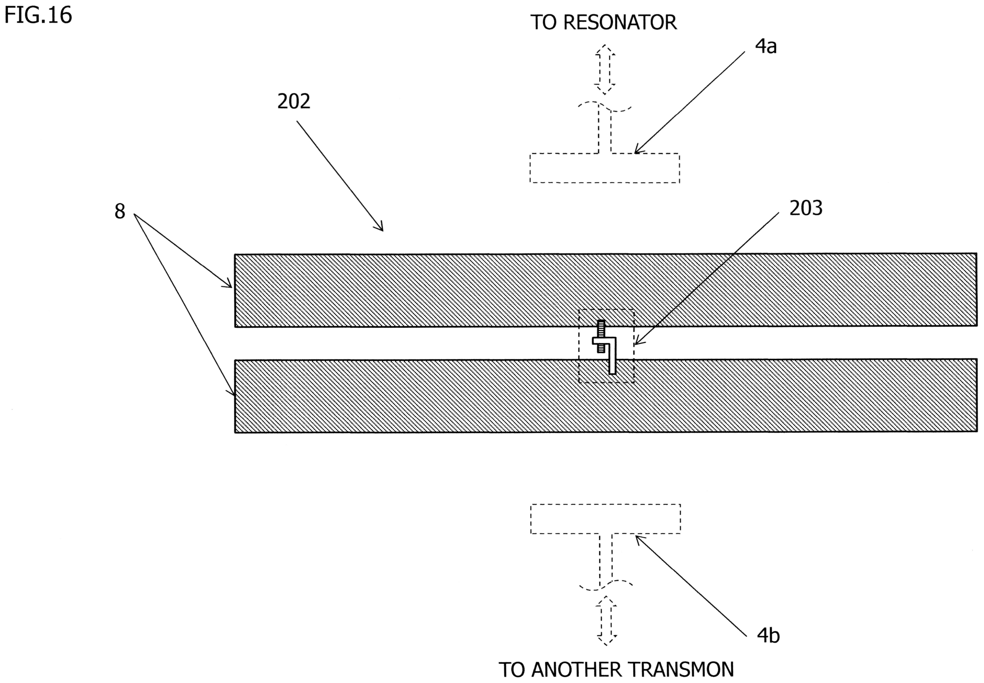

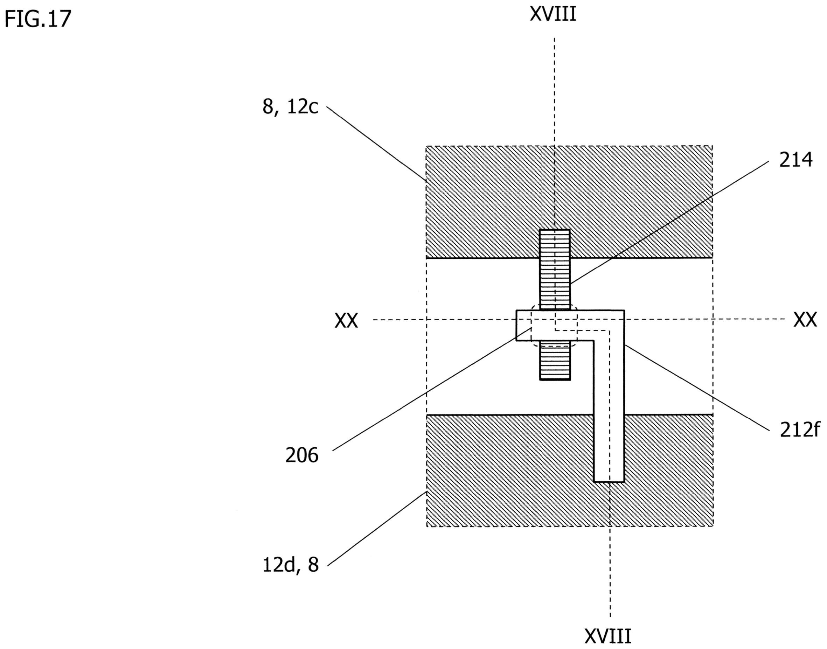

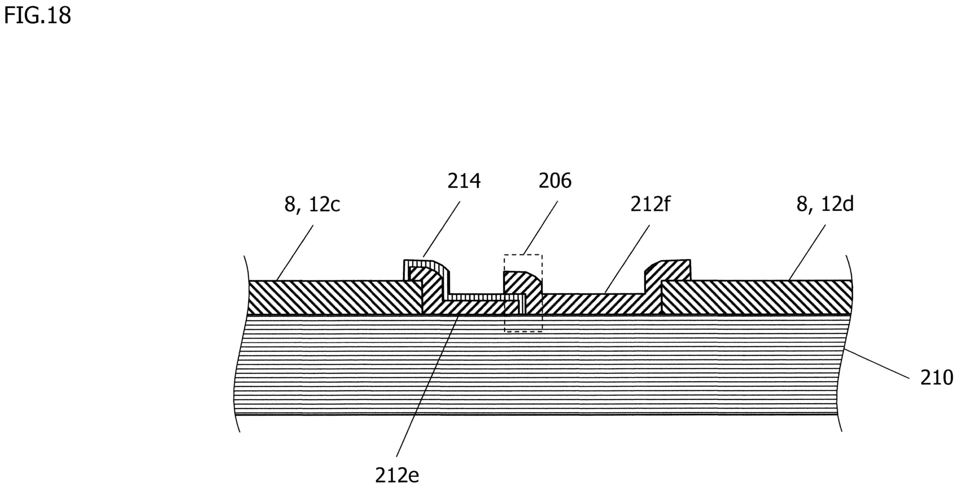

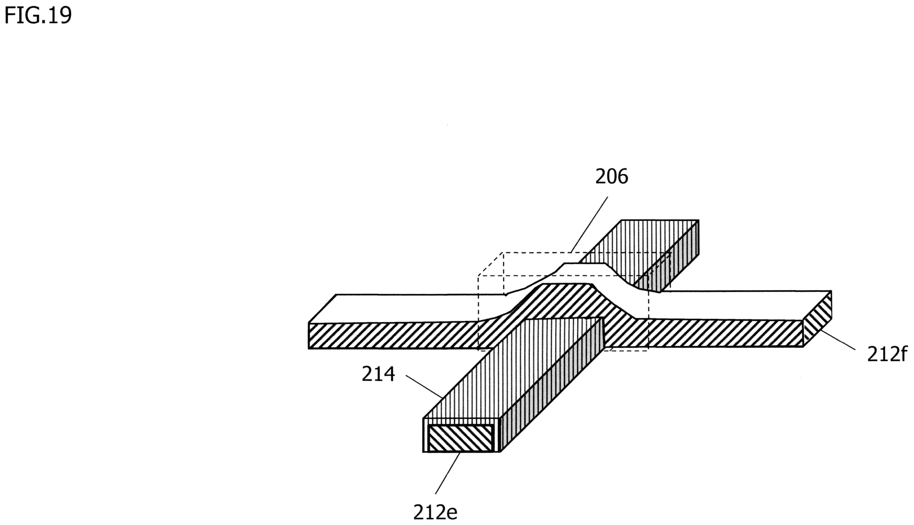

FIG. 16 is a plan view of a quantum bit device 202 (hereinafter, referred to as an oblique angle deposition element) in which a Josephson junction is formed by an oblique angle deposition method. FIG. 17 is an enlarged view of an area 203 surrounded by a broken line in FIG. 16. FIG. 18 is a cross-sectional view taken along line XVIII-XVIII in FIG. 17. FIG. 19 is a perspective view of a Josephson junction 206 (see FIGS. 17 and 18) that the oblique angle deposition element 202 includes and the vicinity thereof.

As illustrated in FIGS. 16 to 18, the oblique angle deposition element 202 is similar to the quantum bit device 2 described with reference to FIGS. 1 to 3. However, the oblique angle deposition element 202 includes a fifth superconductor 212e (see FIG. 18) disposed on a flat surface that the substrate 210 has, instead of the first superconductor 12a (see FIG. 3) disposed inside the groove.

The oblique angle deposition element 202 further includes a sixth superconductor 212f (see FIG. 18) instead of the second superconductor 12b (see FIG. 3). The oblique angle deposition element 202 further includes an oxide film 214 (see FIGS. 18 and 19) that covers the side surface and the upper surface of the fifth superconductor 212e, instead of the barrier layer 14 that covers a portion of the upper surface of the first superconductor 12a.

Therefore, the Josephson junction 206 (see FIGS. 18 and 19) that the oblique angle deposition element 202 has is a junction that includes a portion of the fifth superconductor 212e, a portion of the oxide film 214 (hereinafter, referred to as an intermediate portion), and a portion of the sixth superconductor 212f in this order. The intermediate portion of the Josephson junction 206 is a portion of the oxide film 214, and is a portion located between the fifth superconductor 212e and the sixth superconductor 212f.

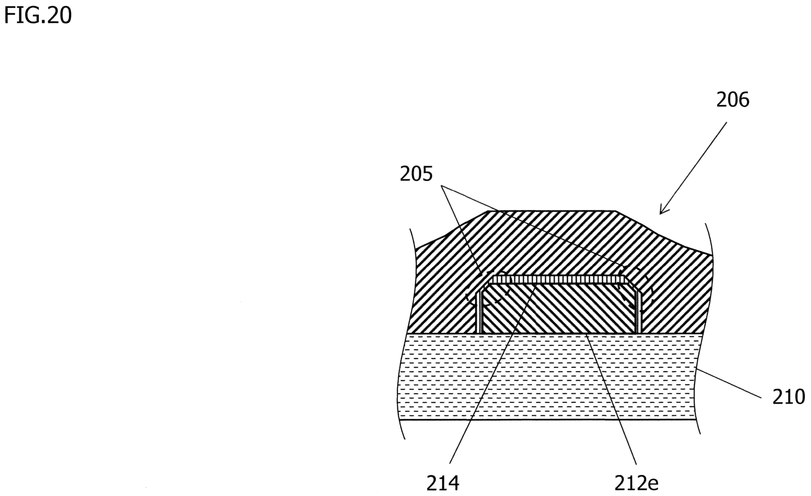

As illustrated in FIG. 19, the oblique angle deposition element 202 includes the sixth superconductor 212f that rides on the fifth superconductor 212e covered with the oxide film 214. FIG. 20 is a cross-sectional view across the Josephson junction 206. Specifically, FIG. 20 is a cross-sectional view taken along line XX-XX in FIG. 17.

The oxide film 214 is formed by exposing the exposed surface of the fifth superconductor 212e (for example, aluminum) to oxygen. Since the fifth superconductor 212e (see FIG. 20) is formed on the substrate 210, the oxide film 214 is formed not only on the upper surface (that is, a surface separated from the substrate 210) of the fifth superconductor 212e but also on the side surface of the fifth superconductor 212e and a corner 205 of the fifth superconductor 212e.

The film thickness of the oxide film 214 at the corner 205 of the fifth superconductor 212e may be thinner than the film thickness on the upper surface of the fifth superconductor 212e and the side surface of the fifth superconductor 212e.

The tunnel resistance R of the Josephson junction decreases as the barrier layer (here, the oxide film 214) becomes thinner. Therefore, when the oxide film 214 is formed thin at the corner 205 of the fifth superconductor 212e, the tunnel resistance R deviates from the planned value (Hereinafter, referred to as a fact 5). When the tunnel resistance R deviates from the planned value, the characteristic of the quantum bit device (here, the oblique angle deposition element 202) that includes the Josephson junction deviates from its target value (that is, the design value) (hereinafter, referred to as a fact 6).

As is clear from the facts 5 and 6, when the oxide film 214 is formed thin at the corner 205 of the fifth superconductor 212e, the characteristic of the oblique angle deposition element 202 deviates from the target value (hereinafter referred to as a conclusion 2).

As described above, the oxide film 214 may be formed thin at the corner 205 of the fifth superconductor 212e. Therefore, as is clear from the conclusion 2, the characteristic of the oblique angle deposition element 202, in which the oxide film 214 may be formed thin at the corner 205, may deviate from the target value. Therefore, the yield of the oblique angle deposition element 202 is low.

Furthermore, the sixth superconductor 212f (see FIG. 19) may be disconnected at or near a location where the sixth superconductor 212f rides on the fifth superconductor 212e. Due to the disconnection, the yield of the oblique angle deposition element 202 further decreases.

On the other hand, as is clear from FIG. 5, the barrier layer 14 according to the first embodiment does not cover the corner (that is, the boundary between the side surface 18 and the upper surface and the vicinity thereof) of the first superconductor 12a. Therefore, it is possible to suppress a decrease in the yield of the quantum bit device 2 according to the first embodiment, the decrease being due to thinning of the barrier layer at the corner of the superconductor.

Furthermore, since the first superconductor 12a according to the first embodiment is disposed inside the groove of the substrate 10, the second superconductor 12b does not ride on the first superconductor 12a. Therefore, the yield of the quantum bit device 2 according to the first embodiment can be prevented from being lowered due to the disconnection of the second superconductor 12b.

### (5-2) Manufacturing method

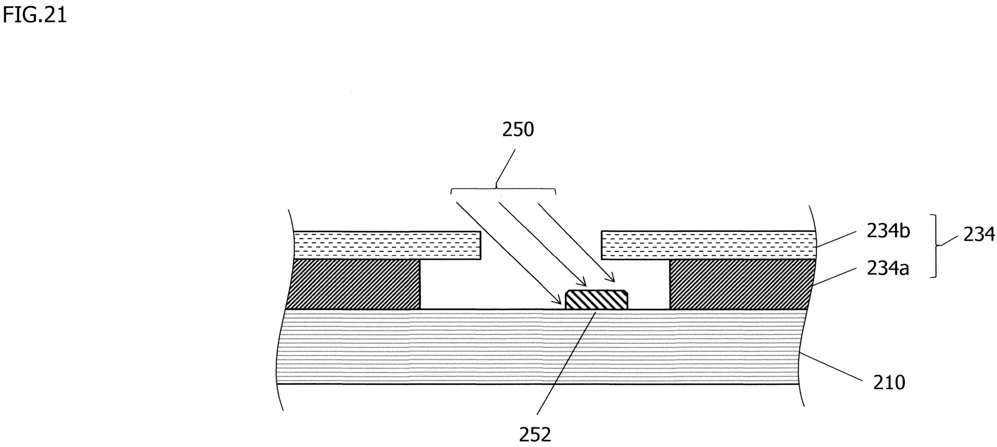

An oblique angle deposition method (that is, a manufacturing method in which oblique angle deposition and lift-off are combined) is used for manufacturing the oblique angle deposition element 202 (see, for example, Non-Patent Literatures 2 and 3). FIG. 21 is a diagram for explaining an oblique angle deposition method.

For the oblique angle deposition method, used is a two-layer resist 234 that includes a lower layer 234a in contact with the substrate 210 and an upper layer 234b that includes eaves. First, material vapor 250 is obliquely made incident on an opening (hereinafter, referred to as a resist opening) of the two-layer resist 234, and a deposition film 252 is deposited on the substrate 210. The oblique angle deposition is performed twice to form a Josephson junction. Thereafter, a deposition film (not illustrated) on the two-layer resist is removed together with the two-layer resist 234. That is, lift-off is executed.

Specifically, the material of the deposition film is evaporated in vacuum, and the material turned into vapor (hereinafter, referred to as material vapor) is adhered to the substrate 210 through the resist opening. The substrate 210 is inclined in advance before the material vapor is adhered to the substrate 210 such that the advancing direction of the material vapor 250 is inclined with respect to the substrate 210.

Accordingly, the deposition film 252 is formed at a position deviated from the center of the resist opening. In the example illustrated in FIG. 21, the material vapor 250 advances from the upper left to the lower right and adheres to the right end of the resist opening.

Thereafter, the substrate 210 is turned, and the material vapor is adhered to the substrate 210 again. Since the advancing direction of the material vapor with respect to the substrate 210 is changed by the turn of the substrate 210, the deposition film (not illustrated) formed by the second deposition is formed at a position different from the position of the deposition film 252 obtained by the first deposition.

In the example illustrated in FIG. 21, in the second oblique angle deposition, the material vapor 250 moves from the upper right toward the lower left. As a result, a deposition film is formed at the left end of the resist opening. Therefore, according to the oblique angle deposition method, the second vapor deposition can be performed while holding the substrate 210 in vacuum (that is, in the evaporative apparatus). After the second deposition, the deposition film (not illustrated) deposited on the two-layer resist 234 is removed together with the two-layer resist 234.

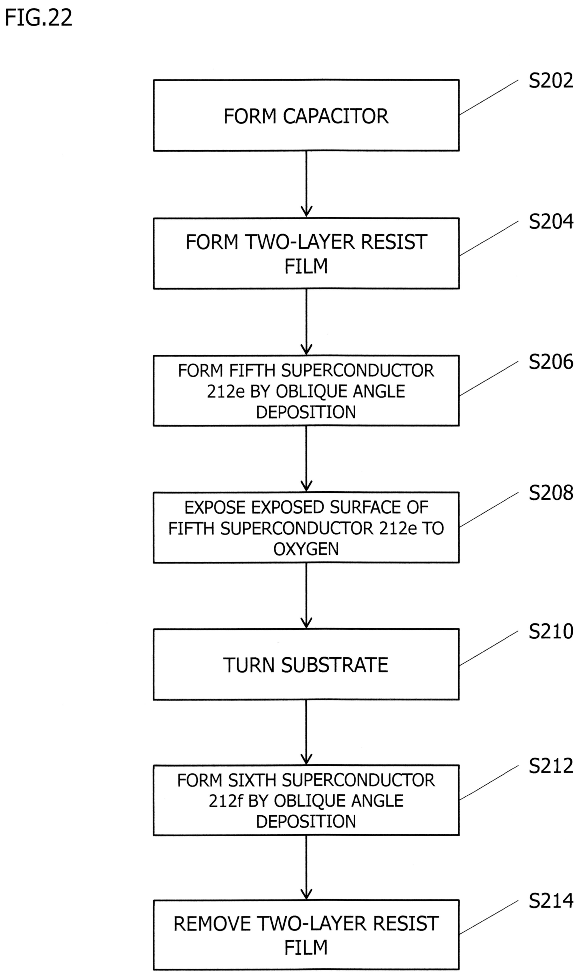

FIG. 22 is a process flowchart that illustrates a method for manufacturing the oblique angle deposition element 202. First, a niobium-made capacitor 8 (see FIG. 18) is formed on the substrate 210 by, for example, lift-off (step S202). Next, a two-layer resist 234 (see FIG. 21) is formed on the substrate 210 (step S204). The fifth superconductor 212e (see FIG. 18) is formed by oblique angle deposition using the two-layer resist 234 (step S206). The fifth superconductor 212e is, for example, aluminum.

Thereafter, oxygen is introduced into the vacuum apparatus in which the deposition of fifth superconductor 212e has been performed. Then, the exposed surface of the fifth superconductor 212e is exposed to oxygen, and the oxide film 214 that covers the fifth superconductor 212e is formed (step S208).

Thereafter, the substrate 210 is turned, and oblique angle deposition of the sixth superconductor 212f is performed (steps S210 and S212). Finally, the two-layer resist 234 is removed from the substrate 210 (step S214).

The deposition film obtained by the oblique angle deposition method becomes thinner as the two-layer resist 234 becomes thicker. However, it is not easy to form the two-layer resist 234 with a specific film thickness and good reproducibility. Therefore, it is difficult to form a deposition film with a specific film thickness and good reproducibility by an oblique angle deposition method. Therefore, the film thicknesses of the fifth and sixth superconductors 212e and 212f formed by the oblique angle deposition method vary greatly (hereinafter, referred to as a fact 7).

The characteristics of the oblique angle deposition element 202, which includes a Josephson junction, depend on the superconducting gap Δ and the tunnel resistance R of the fifth and sixth superconductors 212e and 212f (see "(3) Characteristics"). The superconducting gap Δ depends on the film thickness of the superconductor (see, for example, Non-Patent Literature 4). Therefore, when the variation in the film thickness of the fifth and sixth superconductors 212e and 212f is large, the variation in the characteristics of the oblique angle deposition element 202 is also large (hereinafter, referred to as a fact 8).

As is clear from the facts 7 and 8, characteristics of the oblique angle deposition element 202 varies largely due to the large variation in the film thickness of the fifth and sixth superconductors 212e and 212f. As a result, the yield of the oblique angle deposition elements 202 is low since a large number of oblique angle deposition elements 202 that has characteristics greatly deviated from the target value (that is, the design value) are formed.

Incidentally, as is clear from FIG. 3, the first superconductor 12a according to the first embodiment has substantially the same thickness as the depth of the groove formed in the substrate 10. It is easy to form a groove that has a specific depth in the substrate 10 (for example, silicon substrate) with high reproducibility by using a manufacturing process of a semiconductor device. Therefore, it is easy to form the first superconductor 12a that has a specific film thickness.

The second superconductor 12b according to the first embodiment can be formed by vertical vapor deposition in which material vapor perpendicularly enters the substrate. The vertical vapor deposition is suitable for forming a deposition film that has a specific film thickness. Therefore, it is also easy to form the second superconductor 12b that has a specific film thickness.

Thus, it is easy to make the film thickness of the first and second superconductors 12a and 12b constant. Therefore, it will not happen that the film thickness of the first and second superconductors 12a and 12b varies and the yield of the quantum bit device 2 according to the first embodiment is reduced thereby.

When a superconductor is formed by oblique angle deposition, a superconductor that includes unevenness may be formed. When the fifth superconductor 212e (see FIG. 18) includes unevenness, the surface area of the oxide film 214 increases. Such an oxide film 214 not only reduces the tunnel resistance R of the Josephson junction 206 but also increases variation in the tunnel resistance R. Therefore, the yield of the oblique angle deposition element 202 is also reduced due to the formation of the fifth superconductor 212e that includes unevenness.

On the other hand, since the first superconductor 12a according to the first embodiment includes a flat upper surface (see FIG. 5), such a reduction in yield does not occur in the quantum bit device 2.

### (6) Quantum bit device that includes superconductor embedded in insulating film

A technique has been proposed in which one of two superconductors of a Josephson junction is disposed in a groove formed in an insulating film (for example, SiO₂ film) deposited on a substrate (for example, Patent Literature 2). However, since the insulating film deposited on the substrate has a large dielectric loss, the coherence time of the quantum bit device is shortened.

Therefore, a quantum bit device that includes a superconductor disposed in a groove of an insulating film deposited on a substrate is not preferable. On the other hand, a substrate (for example, a silicon substrate and a sapphire substrate) used for manufacturing a semiconductor device has high quality (that is, the numbers of defects and impurities are small), and therefore has a small dielectric loss. Therefore, by the quantum bit device 2 (see FIG. 3) according to the first embodiment, in which a superconductor is disposed in the groove provided in the substrate, it is possible to suppress shortening of the coherence time due to a dielectric loss.

As described above, according to the first embodiment, since the first superconductor 12a is disposed in the groove provided in the substrate, the barrier layer 14 does not cover the corner of the superconductor where the barrier layer may be formed thin. Therefore, according to the first embodiment, the yield of the quantum bit device 2 becomes high (see "(3) Characteristics" and "(5-1) Structure").

Further, according to the first embodiment, since the variation in the film thickness of the first and second superconductors 12a and 12b can also be suppressed, the yield of the quantum bit device 2 is further increased (see "(3) Characteristics" and "(5-2) Manufacturing method").

### (Second Embodiment)

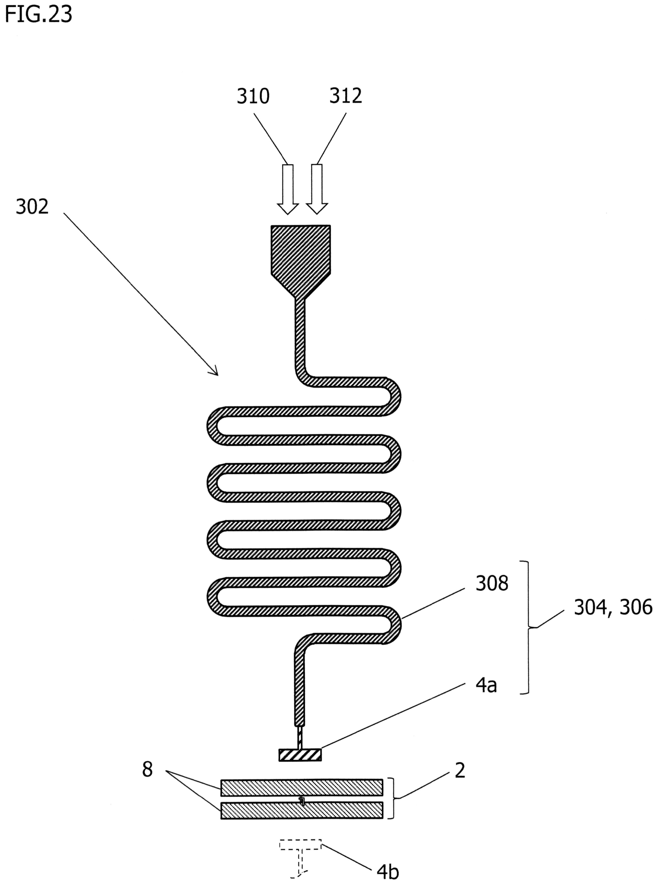

FIG. 23 is a plan view of an example of a quantum bit device (hereinafter, referred to as a quantum bit device 302) according to a second embodiment.

The quantum bit device 2 according to the first embodiment is a quantum bit that includes a Josephson junction 6 (see FIGS. 1 and 2). The quantum bit device 302 according to the second embodiment includes the quantum bit device 2 (hereinafter, referred to as a superconducting quantum bit) according to the first embodiment, and a control unit 304 that controls the quantum state of the superconducting quantum bit 2. The quantum bit device 302 further includes a reading unit 306 that reads out the quantum state of the superconducting quantum bit 2.

In the example illustrated in FIG. 23, the control unit 304 is the same circuit element as the reading unit 306. Specifically, the control unit 304 includes a microwave resonator 308 and a first capacitor 4a. Same, the reading unit 306 includes the microwave resonator 308 and the first capacitor 4a.

The control unit 304 and the reading unit 306 may be circuit elements different from each other (see, for example, Patent Literature 1). The control unit 304 and the reading unit 306 are formed together with the capacitor 8 by lift-off, for example.

The quantum state of the superconducting quantum bit 2 is controlled by a microwave 310 (hereinafter, referred to as a control signal) that is incident on the superconducting quantum bit 2 via the control unit 304. The frequency of the control signal 310 is, for example, a frequency corresponding to an energy difference E₀₁ (see FIG. 6) of the two lowest levels.

The quantum state of the superconducting quantum bit 2 is read out by distributed readout, for example. Specifically, the quantum state of the superconducting quantum bit 2 is read out based on the phase of the reflected wave of the microwave 312 (hereinafter, referred to as a read signal) that is incident on the reading unit 306. The frequency of the read signal 312 is a resonance frequency of the microwave resonator 308 that forms the reading unit or a frequency in the vicinity thereof.

The superconducting quantum bit 2 is connected to another superconducting quantum bit via the second capacitor 4b and a quantum bus (not illustrated). This connection causes quantum entanglement between the superconducting quantum bit 2 and the other quantum bit. Based on the entanglement and superposition in the superconducting quantum bit 2, a quantum calculation is realized.

According to the second embodiment, it is possible to control the quantum state that exits in the superconducting quantum bit 2 according to the first embodiment. According to the second embodiment, it is further possible to read out the quantum state that exists in the superconducting quantum bit 2 according to the first embodiment.

Although the embodiments of the present invention have been described above, the first and second embodiments are illustrative and not restrictive. For example, in the example illustrated in FIG. 3 and the like, the first and second superconductors 12a and 12b are aluminum. However, the first and second superconductors 12a and 12b are not limited to aluminum. For example, the first and second superconductors 12a and 12b may be other superconductor materials (for example, niobium).

In the example illustrated in FIG. 3 and the like, the barrier layer 14 is aluminum oxide. However, the barrier layer 14 is not limited to an oxide such as aluminum oxide. The barrier layer 14 may be, for example, nitride (for example, AIN). Alternatively, the barrier layer 14 may be a normal conductor (for example, Pd).

The barrier layer that is a normal conductor is obtained by, for example, depositing a normal conductor on the substrate 110 through the opening 132 of the two-layer resist film 134, instead of exposing the second portion 130 (see FIG. 13(b)) to oxygen in step S10 (see FIG. 8). In this case, the barrier layer covers the entire lower surface of the second superconductor 120b (see FIG. 15). Therefore, the fourth superconductor 120d is preferably formed so as to be in contact with the upper surface of the second superconductor 120b after the second superconductor 120b is formed.

In the example illustrated in FIG. 3 and the like, the Josephson junction 6 is a junction that includes aluminum, aluminum oxide, and aluminum in this order. However, the Josephson junction 6 is not limited to such a junction. The Josephson junction 6 may be, for example, a junction that includes Nb, AIN, and Nb in this order.

In the example illustrated in FIG. 5 and the like, the first superconductor 12a includes the curved surface 20 between the side surface and the lower surface. However, it is acceptable that the first superconductor 12a does not include the curved surface 20. For example, when the electric field concentration toward the corner of the first superconductor 12a does not cause a problem, it is acceptable that the first superconductor 12a does not include such a curved surface.

In the example illustrated in FIG. 5 and the like, the upper surface of the first superconductor 12a is a flat surface. However, it is acceptable that the upper surface of the first superconductor 12a is not a flat surface. The upper surface of the first superconductor 12a may be, for example, a curved surface recessed inward of the first superconductor 12a. Even in such a case, since the barrier layer 14 does not cover the corner of the first superconductor 12a, the yield of the quantum bit device 2 is high.

The quantum bit device 2 illustrated in FIG. 1 and the like is a transmon that is a type of charge-type quantum bit. However, the quantum bit device of the embodiments may be a quantum bit other than a transmon. For example, the quantum bit device of the embodiments may be a magnetic flux quantum bit.

In this case, the quantum bit device of the embodiment is a superconductor loop that includes the Josephson junction 6. It is acceptable that the superconductor loop does not include the third and fourth superconductors 12c and 12d. Therefore, it is acceptable that the third and fourth superconductors 12c and 12d are not formed.

In the example illustrated in FIG. 1 and the like, the Josephson junction 6 (see FIG. 2) is a part of the quantum bit. However, it is acceptable that the Josephson junction 6 is not a part of the quantum bit. For example, the Josephson junction 6 may be a part of a superconducting quantum interference device (SQUID) that reads out the quantum state of a magnetic flux quantum bit.

### REFERENCE SIGNS LIST

- 2: : quantum bit device
- 6: : Josephson junction
- 10: : substrate
- 12a: : first superconductor
- 12b: : second superconductor
- 12c: : third superconductor
- 12d: : fourth superconductor
- 14: : barrier layer
- 106: : Josephson junction
- 110: : substrate
- 116: : groove
- 120a: : first superconductor
- 120b: : second superconductor
- 120c: : third superconductor
- 120d: : fourth superconductor
- 302: : quantum bit device
- 304: : control unit
- 306: : reading unit

## Claims

1. A quantum bit device comprising:
a substrate; and
a Josephson junction, wherein
the substrate includes a groove, and
the Josephson junction includes:
a first superconductor disposed inside the groove;
a barrier layer in contact with an upper surface of the first superconductor; and
a second superconductor in contact with an upper surface of the barrier layer.

2. The quantum bit device according to claim 1, wherein
the first superconductor is metal, and
the barrier layer is a substance obtained by oxidizing the metal.

3. The quantum bit device according to claim 1 or 2, wherein
a first quantum state and a second quantum state that has higher energy than energy of the first quantum state exist therein.

4. The quantum bit device according to claim 1 or 2, wherein
the first superconductor includes a lower surface in contact with a bottom of the groove, a side surface in contact with a side wall of the groove, and a curved surface located between the lower surface and the side surface.

5. The quantum bit device according to claim 1 or 2, wherein
the first superconductor includes a plane that is separated from a bottom of the groove and is in contact with the barrier layer.

6. The quantum bit device according to claim 1 or 2, further comprising
a third superconductor in contact with the first superconductor, and a fourth superconductor in contact with the second superconductor.

7. The quantum bit device according to claim 1 or 2, wherein
the substrate is silicon or sapphire.

8. The quantum bit device according to claim 1 or 2, further comprising:
a control unit that controls a quantum state of a quantum bit that includes the Josephson junction; and
a reading unit that reads out the quantum state.

9. A method for manufacturing a quantum bit device, the method comprising:
a first step of forming a groove in a substrate;
a second step of depositing a first superconductor on an upper surface of the substrate and inside the groove;
a third step of removing a first portion of the first superconductor, the first portion being formed on the upper surface of the substrate;
a fourth step of forming a barrier layer on a first upper surface of the first superconductor after the third step; and
a fifth step of forming a Josephson junction by forming a second superconductor on an upper surface of the barrier layer.

10. The method for manufacturing the quantum bit device according to claim 9, wherein
the first step is a step of forming the groove by forming a first groove in the substrate by dry etching and then removing a portion of the substrate by wet etching, the portion being in contact with the first groove.

11. The method for manufacturing the quantum bit device according to claim 9 or 10, wherein
the third step is a step of removing the first portion by chemical mechanical polishing.

12. The method for manufacturing the quantum bit device according to claim 9 or 10, wherein
the fourth step is a step of forming the barrier layer by exposing a second portion of the first upper surface of the first superconductor to oxygen, and
the first upper surface is a surface included in the first superconductor, and is a surface that is separated from a bottom of the groove and includes an outer periphery in contact with each side surface of the groove.

13. The method for manufacturing the quantum bit device according to claim 9 or 10, further comprising
a sixth step of forming a third superconductor in contact with a portion of the first superconductor and a fourth superconductor between the third step and the fourth step, wherein
the fifth step is a step of forming the second superconductor in contact with the fourth superconductor and the barrier layer.

14. The method for manufacturing the quantum bit device according to claim 12, wherein
the fourth step is a step of forming the barrier layer by exposing the second portion to the oxygen after removing or reducing an oxide film that covers the second portion.

15. The method for manufacturing the quantum bit device according to claim 13, wherein
the sixth step is a step of forming the third superconductor and the fourth superconductor after removing or reducing an oxide film that covers the first upper surface of the first superconductor, and
the first upper surface is a surface included in the first superconductor, and is a surface that is separated from a bottom of the groove and includes an outer periphery in contact with each side surface of the groove.
